# EUROPÄISCHE PATENTSCHRIFT

(11) **EP 0 620 643 B1**
(45) Veröffentlichungstag und Bekanntmachung des Hinweises auf die Patenterteilung: **24.02.1999**
(21) Anmeldenummer: 94104285.5
(22) Anmeldetag: 18.03.1994
(51) Int. Cl.: H03J 1/00

(54) **Schaltungsanordnung zur Erzeugung eines Stopp-Signals für einen Sendersuchlauf**
Circuit for generating a stop signal for a scanning action
Circuit pour générer un signal d'arrêt pour une action de balayage

(30) Priorität: 10.04.1993 DE 4311933
(43) Veröffentlichungstag der Anmeldung: 19.10.1994
(73) Patentinhaber: Blaupunkt-Werke GmbH, D-31139 Hildesheim (DE)
(72) Erfinder: Herrmann, Matthias Dr., D-31141 Hildesheim (DE)

(56) Entgegenhaltungen:
- GB-A- 2 100 084
- US-A- 4 580 285

## Beschreibung

Die Erfindung betrifft eine Schaltungsanordnung zur Erzeugung eines Stopp-Signals für einen Sendersuchlauf in einem Rundfunkempfänger, bei welchem ein empfangenes Signal demoduliert wird und ferner ein von der jeweiligen Feldstärke abhängiges Signal abgeleitet wird.

Beim Suchen eines empfangswürdigen Senders muß der Rundfunkempfänger im Suchlauf-Betrieb selbständig erkennen, ob die Abstimmung auf Sendermitte erfolgt ist und ob der Sender eine ausreichende Feldstärke aufweist. Wenn diese Bedingungen erfüllt sind, ist ein Stopp-Signal zu erzeugen, welches den Suchlauf anhält.

Aus der US-A-4 580 285 ist ein AM-Rundfunkempfänger bekannt, bei dem ein empfangenes Signal demoduliert wird, und der eine Schaltungsanordnung zur Erzeugung eines Stoppsignals für einen Sendersuchlauf aufweist. Dazu wird mittels einer dafür vorgesehenen Schaltung aus dem Ausgangssignal der AGC-Schaltung ein von der jeweiligen Empfangsfeldstärke abhängiges Signal abgeleitet und außerdem das am Ausgang eines mit dem ZF-Verstärker verbundenen FM-Detektors anstehende Gleichspannungssignal, das das Maß einer eventuellen Abweichung der Abstimmung des Rundfunkempfängers von der tatsächlichen Sendefrequenz anzeigt, bestimmt. Ein Suchlauf-Stopp-Signal wird unter Auswertung dieser beiden Signale dann erzeugt, wenn der Gleichspannungsanteil unter und die Feldstärke über einem vorgegebenen Wert liegt.

Weiterhin ist aus der GB-A-2 100 084 eine automatische Sendersuchlauf-Schaltung für einen FM-Rundfunkempfänger bekannt, bei der ein die Empfangsfeldstärke eines jeweilig empfangenen Rundfunksenders anzeigendes Signal und ein aus einem Gleichspannungsanteil des demodulierten Signals abgeleitetes Signal, das das Maß einer Abweichung von einer idealen Sendermittenabstimmung anhand eines S-förmigen Verlaufs des Gleichspannungsanteils über der Frequenzabweichung anzeigt, miteinander zur Bildung eines Suchlauf-Stopp-Signals dann verknüpft werden, wenn der Gleichspannungsanteil im demodulierten Signal unter einem vorgegebenen Wert und die Empfangsfeldstärke über einem vorgegebenen Wert liegt.

### Vorteile der Erfindung

Die erfindungsgemäße Schaltungsanordnung mit den Merkmalen des Hauptanspruchs hat demgegenüber den Vorteil, daß der Schaltungsanordnung zur Ableitung des Suchlauf-Stopp-Signals das demodulierte Signal in digitaler Form mit einer ersten Abtastrate zugeführt ist, die innerhalb der Anordnung auf eine zweite Abtastrate reduziert wird. Daraus ergibt sich der Vorteil, daß die Demodulation des empfangenen Rundfunksignals mit einer sehr hohen Abtastrate und damit mit geringen Quantisierungsfehlern und somit geringen Signalverzerrungen erfolgen kann, während die Ableitung des Gleichspannungssignals und auch des Empfangsfeldstärkesignals mit einer niedrigen Abtastrate und damit mit erheblich reduziertem Rechenaufwand erfolgen kann.

Die Ableitung des Gleichspannungsanteils des demodulierten Signals erfolgt vorzugsweise derart, daß der Gleichspannungsanteil durch Tiefpaßfilterung und durch Betragsbildung abgeleitet wird.

Bei der Reduzierung der Abtastrate von einer ersten hohen auf eine zweiten niedrige Abtastrate ist es von Vorteil, wenn die erste Abtastrate ein ganzzahliges Vielfaches der zweiten Abtastrate beträgt.

Hierbei ist vorzugsweise vor der Abtastratenreduzierung ein Tiefpaßfilter vorgesehen, das als FIR-Filter ausgebildet ist, bei dem eine Anzahl von jeweils um eine Abtastperiode entsprechend der ersten Abtastrate zueinander verzögerte Signale mit Koeffizienten bewertet addiert werden und die Anzahl der Signale gleich dem Verhältnis der ersten Abtastrate zur zweiten Abtastrate ist.

Dieses hat den Vorteil, daß die Bildung des Gleichspannungsanteils nicht dadurch verfälscht wird, daß bei Verwendung anderer Filter zur Dezimation höherfrequente Anteile auf den unteren Frequenzbereich und damit auf den später auszuwertenden Gleichspannungsanteil gespiegelt werden.

Eine vorteilhafte Auslegung besteht darin, daß die erste Abtastrate 228 kHz beträgt, daß die zweite Abtastrate gleich 9,5 kHz ist und daß bei 23 Verzögerungselementen die Anzahl der Signale 24 beträgt.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer erfindungsgemäßen Schaltungsanordnung,
- Fig. 2: eine vorteilhafte Ausgestaltung eines ersten Tiefpaßfilters bei der Schaltungsanordnung nach Fig. 1, und
- Fig. 3: eine Ausgestaltung von weiteren Tiefpaßfiltern in der Schaltungsanordnung nach Fig. 1.

Gleiche Teile sind in den Figuren mit gleichen Bezugszeichen versehen.

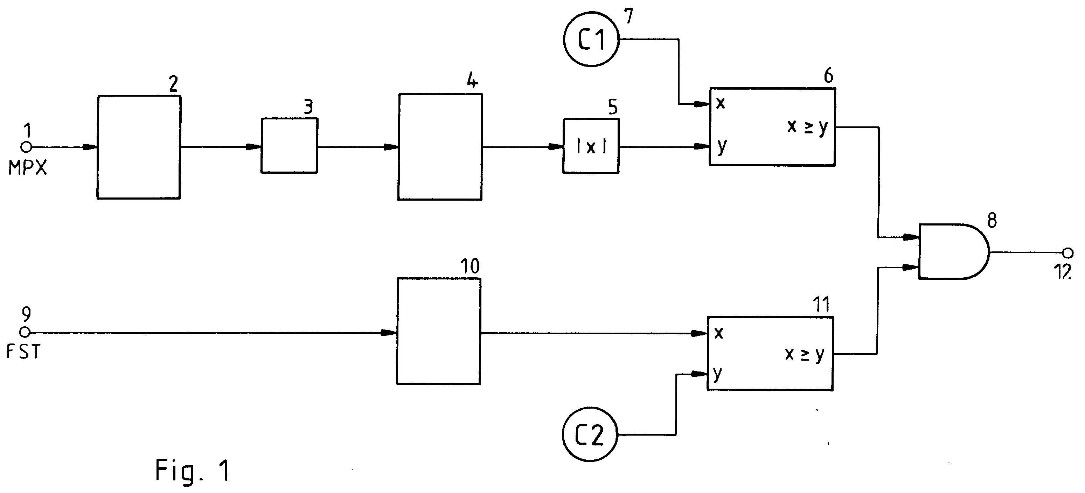

Bei der Schaltungsanordnung nach Fig. 1 wird bei 1 ein Stereo-Multiplexsignal MPX zugeführt, das eine Abtastrate von 228 kHz aufweist, welche sich als vorteilhaft bei der vorangegangenen digitalen Signalverarbeitung herausgestellt hat. Da bei der erfindungsgemäßen Schaltungsanordnung eine wesentlich niedrigere Abtastrate genügt, wird das Stereo-Multiplexsignal MPX über einen Tiefpaß 2 zu einer Schaltung 3 zur Abtastratenreduzierung um den Teiler 24 geleitet. Das resultierende Signal wird einem weiteren Tiefpaß 4 zugeführt, dessen Grenzfrequenz sehr niedrig ist, so daß sich an seinem Ausgang praktisch nur der Gleichspannungsanteil ergibt, von welchem bei 5 der Betrag gebildet wird. Dieser wird in einem Komparator 6 mit einer bei 7 zugeführten Konstanten C1 von beispielsweise 0,07 (bezogen auf die Maximalamplitude) verglichen. Ist der Betrag des Gleichspannungsanteils kleiner als die Konstante C1, erscheint am Ausgang x≥y des Komparators 6 eine 1, die einem Eingang einer Und-Schaltung 8 zugeleitet wird.

Einem weiteren Eingang 9 der Schaltungsanordnung nach Fig. 1 wird ein Signal FST zugeleitet, welches der Feldstärke des jeweils empfangenen Signals entspricht. Dieses Signal wird bei 10 tiefpaßgefiltert und bei 11 mit einer Konstanten C2 verglichen. Ist die Feldstärke größer als ein durch die Konstante C2 vorgegebener Wert, so erscheint am Ausgang x≥y des Komparators 11 eine 1, die ebenfalls zur Und-Schaltung 8 geleitet wird. Sind beide Bedingungen erfüllt, so nimmt das Stopp-Signal SLS am Ausgang 12 der Und-Schaltung 8 ebenfalls den Pegel 1 an.

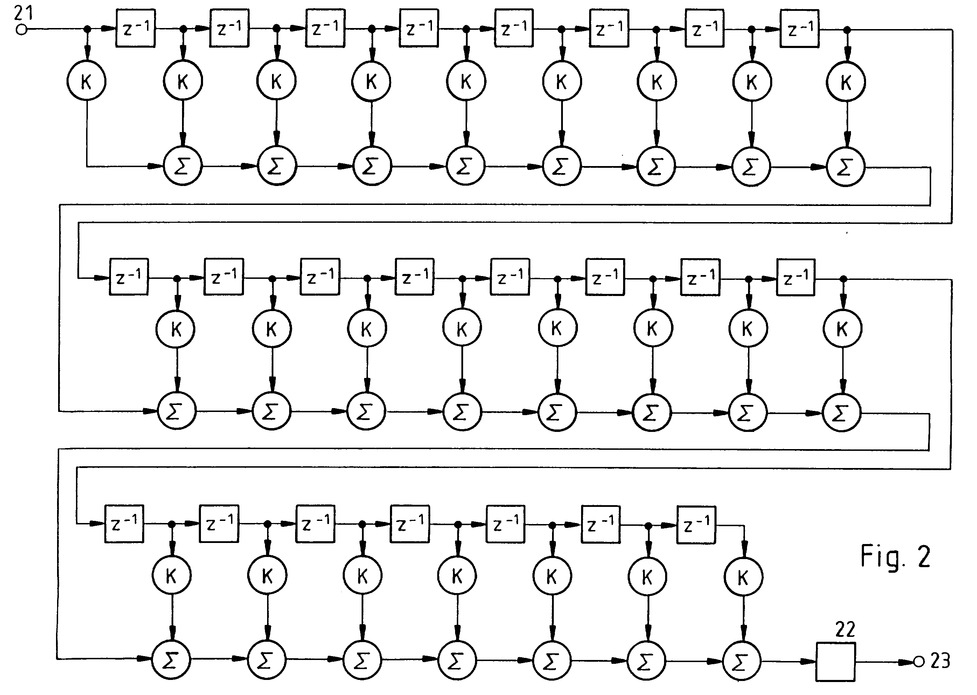

Fig. 2 zeigt ein vorteilhaftes Ausführungsbeispiel des Tiefpaßfilters 2 (Fig. 1). Es ist als FIR-Filter 23. Ordnung ausgebildet, welches die speziellen Eigenschaften eines Kammfilters aufweist. Das dem Eingang 21 zugeführte Stereo-Multiplexsignal wird 23 mal um jeweils eine Abtastperiode verzögert (z⁻¹). Das Eingangssignal und das jeweils um n mal verzögerte Signal werden jeweils mit einem Koeffizienten K multipliziert, der bei einem bevorzugten Ausführungsbeispiel 1/24 beträgt. Während das zugeführte Signal eine Bitbreite von 16 aufweist, sind die Produkte der verzögerten Signale mit den Koeffizienten 24 Bit breit, um Quantisierungsfehler zu vermindern. Die Produkte werden dann in Summierschaltungen aufsummiert und bilden nach einer Formatwandlung bei 22 am Ausgang 23 das tiefpaßgefilterte Stereo-Multiplexsignal mit einer Bitbreite von 16.

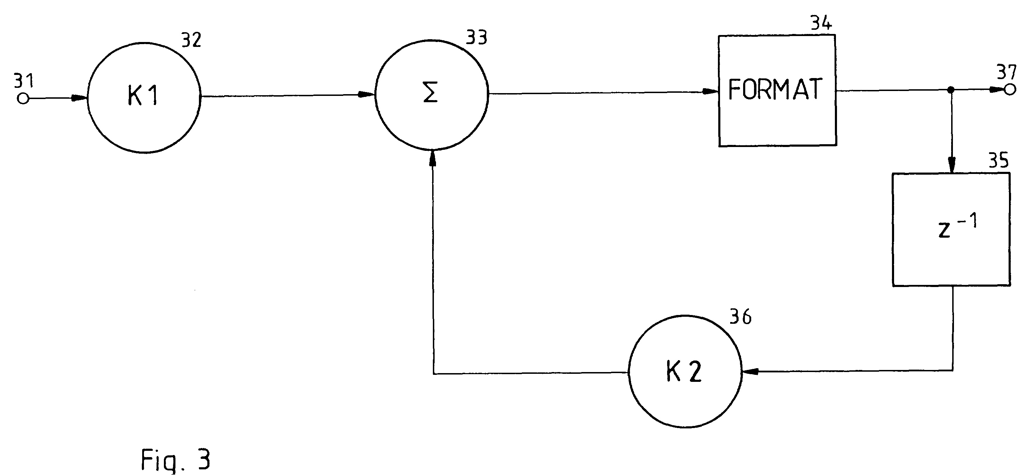

Fig. 3 zeigt ein Ausführungsbeispiel für eines der Filter 4 oder 10, das als rekursives Filter erster Ordnung ausgebildet ist. Dem Eingang 31 ist entweder das Stereo-Multiplexsignal MPX nach dessen Abtastratenreduzierung oder das Feldstärkesignal FST zuführbar. Beide werden zunächst mit einer ersten Konstanten K1 multipliziert. Das Ausgangssignal des Multiplizierers 32 stellt ein 24 Bit breites Signal dar, das der Addierschaltung 33 zugeführt wird. Die Summe wird nach einer Formatwandlung 34 in ein 16 Bit breites Signal um eine Abtastperiode bei 35 verzögert und nach einer Bewertung mit einer Konstanten K2 bei 36 einem weiteren Eingang des Addierers 33 zugeleitet. Am Ausgang 37 kann das gefilterte Signal, das heißt der Gleichspannungsanteil des Stereo-Multiplexsignals oder das tiefpaßgefilterte Feldstärkesignal, entnommen werden.

## Patentansprüche

1. Schaltungsanordnung zur Erzeugung eines Stopp-Signals für einen Sendersuchlauf in einem Rundfunkempfänger, bei dem ein von der jeweiligen Empfangsfeldstärke abhängiges Signal abgeleitet wird, und bei dem ein empfangenes Signal demoduliert und der Gleichspannungsanteil des demodulierten Signals gebildet wird, wobei ein Stopp-Signal erzeugt wird, wenn der Gleichspannungsanteil unter einem vorgegebenen Wert und die Empfangsfeldstärke über einem vorgegebenen Wert liegt, dadurch gekennzeichnet, daß das in digitaler Form vorliegende demodulierte Signal der Schaltungsanordnung mit einer ersten Abtastrate zugeführt ist, die innerhalb der Schaltungsanordnung auf eine zweite Abtastrate reduziert wird, wobei das demodulierte Signal mit der zweiten Abtastrate zur Erzeugung des Stopp-Signals verwendet wird.

2. Schaltungsanordnung nach Anspruch 1, dadurch gekennzeichnet, daß die erste Abtastrate ein ganzzahliges Vielfaches der zweiten Abtastrate ist.

3. Schaltungsanordnung nach einem der vorhergehenden Ansprüche, dadurch gekennzeichnet, daß das demodulierte Signal ein Stereo-Multiplexsignal ist.

4. Schaltungsanordnung nach einem der vorhergehenden Ansprüche, dadurch gekennzeichnet, daß der Gleichspannungsanteil des demodulierten Signals in der Ebene der zweiten Abtastrate bestimmt wird.

5. Schaltungsanordnung nach einem der vorhergehenden Ansprüche, dadurch gekennzeichnet, daß zur Gewinnung des Gleichspannungsanteils des demodulierten Signals ein Betragsbildner (5) eingesetzt wird.

6. Schaltungsanordnung nach einem der vorhergehenden Ansprüche, dadurch gekennzeichnet, daß vor der Abtastratenreduzierung (3) ein Tiefpaßfilter (2) vorgesehen ist, das als FIR-Filter ausgebildet ist, bei dem eine Anzahl von jeweils um eine Abtastperiode entsprechend der ersten Abtastrate zueinander verzögerte Signale mit Koeffizienten (K) bewertet addiert werden und die Anzahl der Signale gleich dem Verhältnis der ersten Abtastrate zur zweiten Abtastrate ist.

7. Schaltungsanordnung nach einem der vorhergehenden Ansprüche, dadurch gekennzeichnet, daß die erste Abtastrate 228kHz beträgt, daß die zweite Abtastrate gleich 9,5kHz ist und daß bei 23 Verzögerungselementen die Anzahl der Signale 24 beträgt.

8. Schaltungsanordnung nach einem der vorhergehenden Ansprüche, dadurch gekennzeichnet, daß das Feldstärkesignal vor der Schwellwertentscheidung (11) mittels eines Tiefpasses (10) gefiltert wird.

## Claims

1. Circuit arrangement for generating a stop signal for a transmitter search in a broadcast radio receiver, in which a signal which is dependent on the respective received field strength is derived, and in which a received signal is demodulated and the DC voltage component of the demodulated signal is formed, a stop signal being generated if the DC voltage component lies below a predetermined value and the received field strength lies above a predetermined value, characterized in that the demodulated signal, which is present in digital form, is fed to the circuit arrangement at a first sampling rate, which is reduced to a second sampling rate within the circuit arrangement, the demodulated signal at the second sampling rate being used for the purpose of generating the stop signal.

2. Circuit arrangement according to Claim 1, characterized in that the first sampling rate is an integer multiple of the second sampling rate.

3. Circuit arrangement according to one of the preceding claims, characterized in that the demodulated signal is a stereo multiplex signal.

4. Circuit arrangement according to one of the preceding claims, characterized in that the DC voltage component of the demodulated signal is determined at the level of the second sampling rate.

5. Circuit arrangement according to one of the preceding claims, characterized in that an absolute-value generator (5) is used to obtain the DC voltage component of the demodulated signal.

6. Circuit arrangement according to one of the preceding claims, characterized in that a low-pass filter (2) is provided upstream of the sampling rate reduction (3), which filter is designed as an FIR filter, in which a number of signals, which are each delayed with respect to one another by a sampling period in accordance with the first sampling rate, are added, in a manner weighted with coefficients (K), and the number of signals is equal to the ratio of the first sampling rate to the second sampling rate.

7. Circuit arrangement according to one of the preceding claims, characterized in that the first sampling rate is 228 kHz, in that the second sampling rate is equal to 9.5 kHz, and in that, given 23 delay elements, the number of signals is 24.

8. Circuit arrangement according to one of the preceding claims, characterized in that the field strength signal is filtered by means of a low-pass filter (10) upstream of the threshold value decision (11).

## Revendications

1. Circuit servant à produire un signal d'arrêt pour une recherche d'émetteur par balayage dans un récepteur radio, dans lequel on prélève un signal qui est fonction de l'intensité respective du champ de réception, et dans lequel on démodule un signal reçu et on forme la fraction à tension continue du signal démodulé, en produisant un signal d'arrêt quand la fraction à tension continue se trouve en dessous d'une valeur prédéfinie et quand l'intensité du champ de réception se trouve en dessus d'une valeur prédéfinie,
caractérisé en ce que
le signal démodulé du circuit qui se trouve sous la forme numérique est amené avec un premier taux de balayage, qui est ramené à l'intérieur du circuit à un deuxième taux de balayage, le signal démodulé étant utilisé avec le deuxième taux de balayage pour produire le signal d'arrêt.

2. Circuit selon la revendication 1,
caractérisé en ce que le premier taux de balayage est un multiple entier du deuxième taux de balayage.

3. Circuit selon l'une des revendications précédentes,
caractérisé en ce que
le signal démodulé est un signal multiplex stéréo.

4. Circuit selon l'une des revendications précédentes,
caractérisé en ce que
la fraction à tension continue du signal démodulé est déterminée dans le plan du deuxième taux de balayage.

5. Circuit selon l'une des revendications précédentes,
caractérisé en ce qu'
on insère pour obtenir la fraction à courant continu du signal démodulé un élément (5), qui forme la valeur absolue.

6. Circuit selon l'une des revendications précédentes,
caractérisé en ce qu'
on prévoit avant la réduction du taux de balayage (3) un filtre passe-bas (2) qui est constitué sous la forme d'un filtre FIR, dans lequel on additionne un certain nombre de signaux, valorisés par des coefficients (K) qui sont retardés les uns par rapport aux autres d'une période de balayage qui correspond au premier taux de balayage, et dans lequel le nombre des signaux est égal au rapport entre le premier taux de balayage et le deuxième taux de balayage ;

7. Circuit selon l'une des revendications précédentes,
caractérisé en ce que
- le premier taux de balayage atteint 228 kHz,
- le deuxième taux de balayage est égal à 9,5 kHz et
- dans le cas de 23 éléments de temporisation le nombre des signaux est de 24.

8. Circuit selon l'une des revendications précédentes,
caractérisé en ce que
le signal d'intensité du champ est filtré avant le décideur de seuil (11) au moyen d'un filtre passe-bas (10).
